# EUROPEAN PATENT APPLICATION

(11) **EP 1 914 286 A1**
(43) Date of publication of application: **23.04.2008**
(21) Application number: 06782286.6
(22) Date of filing: 03.08.2006
(51) Int. Cl.: C09K 3/14, H05K 3/26

(54) **POLISHING COMPOSITION AND POLISHING METHOD**

(30) Priority: 04.08.2005 JP 2005226177
(71) Applicant: Asahi Glass Company, Limited, Chiyoda-ku Tokyo 100-8405 (JP); AGC Seimi Chemical Co., Ltd., Chigasaki-shi, Kanagawa 253-8585 (JP)
(72) Inventor: KAMIYA, Hiroyuki, c/o Asahi Glass Company, Limited, Tokyo 100-8405 (JP); TSUGITA, Katsuyuki, c/o AGC SEMI CHEMICAL.LTD, Chigasaki-shi Kanagawa 253-8585 (JP)
(74) Representative: Müller-Boré & Partner Patentanwälte
(86) International application number: PCT/JP2006/315426
(87) International publication number: WO 2007/015551

(57) **Abstract**

To provide a polishing compound that is capable of minimizing formation of scratches on an object to be polished, such as a resin substrate or a metal wiring, and polishing at a high removal rate. To further provide a polishing method that is capable of minimizing formation of scratches on a resin substrate or a metal wiring, and improving the throughput.

The polishing compound T comprises an oxidizing agent, an electrolyte and an aqueous medium, wherein ions formed from the electrolyte comprise ammonium ions, at least one type of organic carboxylate ions selected from the group consisting of polycarboxylate ions and hydroxycarboxylate ions, and at least one type of ions selected from the group consisting of carbonate ions, hydrogencarbonate ions, sulfate ions and acetate ions.

A wiring trench 2 is formed in a resin substrate 1, then a wiring metal 3 is embedded in the wiring trench 2, and the wiring metal 3 is polished by using the above-mentioned polishing compound, whereby it is possible to minimize formation of scratches on the metal wiring 3 and to improve the throughput.

## Description

### TECHNICAL FIELD

The present invention relates to a polishing compound and a polishing method.

### BACKGROUND ART

Recently, along with the progress in the integration and functionality of semiconductor devices, there has been a demand for development of micro-fabrication techniques for processes of producing the semiconductor devices. Particularly, planarization techniques for interlayer insulating films and embedded wirings are important in processes of forming multilayered wirings. That is, as patterns are formed in insulating films or metal films, complex unevennesses are caused on the surface of a semiconductor wafer. The difference in level resulting from the unevennesses tends to increase as wirings are multilayered. Accordingly, if more patterns were formed on the semiconductor wafer, the depth of the focus in a lithographic method would become shallow for transferring patterns, resulting in a problem such that desired patterns would not be formed. Therefore, techniques to planarize the surface of the semiconductor wafer with high accuracy are needed.

CMP (Chemical Mechanical Polishing) has been used as one of such planarization techniques. The CMP method is used, for instance, when copper is embedded into an interlayer insulating film in a process of forming copper wiring by a Damascene method. Specifically, it is a technique to eliminate the difference in level on the surface of the semiconductor wafer by both chemical and mechanical actions. According to the technique, it is possible to remove convex portions, while controlling processing of concave portions.

Now, in semiconductor production processes, a technique related to a wiring board is one of the important elemental technologies. A wiring board plays a role to have semiconductor packages or bare chips mounted, supported and fixed thereon, and simultaneously, to establish an electrical connection between the packages and chips.

Thus, by this technology, a materially stabilized highly dense multilayered wiring structure may be formed by combining various core materials of supporting boards; various conductive materials that work as electrically connecting wirings, and insulating materials that insulate between the respective signal wirings.

Depending on types of the base core materials, wiring boards may be generally classified into organic wiring boards and inorganic wiring boards. Organic wiring boards, which are represented by printed wiring boards, are used as mounted wiring boards for high-speed devices, since their dielectric constant is lower than that of inorganic wiring boards.

Conventional organic wiring boards are prepared, for instance, as disclosed in Patent Document 1. Namely, in a resin substrate, trenches for wiring circuits or holes for via hole connections are formed, and then, the trenches and the holes are filled with an electrical conductive material. Then, an excessive amount of the electric conductive material is removed and the surface is planarized by polishing, and bare chips are mounted on the resin substrate. In this case, polishing means mechanical polishing, which is carried out, for instance, by_moving a polishing film coated with white alundum abrasive particles, on the resin substrate. However, the mechanical polishing has a risk of causing scratches on wiring metals or resin substrates, although it has an advantage of high removal rate.

On the other hand, in the above-mentioned CMP method, a slurry comprising abrasive particles and reagents, is used. The CMP method is a type of polishing wherein mechanical and chemical actions are used in combination, so that less scratch is caused as compared to the mechanical polishing. However, the conventional CMP method has had a problem that when it is used to produce organic wiring boards, the throughput decreases because of the low removal rate.

Here, with respect to the removal rate in the CMP method, a method is suggested to accelerate the removal rate by adding an inorganic ammonium salt to a polishing agent to shift the pH to an alkaline side (Patent Document 2). Further, a method of adjusting the removal rate of metal constituting a wiring metal layer or a barrier layer, by a polishing pressure and a polishing compound, is also suggested (Patent Documents 3 and 4).

However, all of these are targeting only the situation of forming metal wirings on semiconductor boards, like silicon wafers, but they do not discuss about the situation of forming metal wirings on a resin substrate, provided on a supporting board.

In addition, Patent Documents 3 and 4 describe about using a salt of an organic or inorganic acid with a basic compound, as an agent for adjusting the removal rate. However, the purpose of the agent for adjusting the removal rate is to lower the removal rate of a wiring metal layer, thereby to raise the polishing selectivity for a barrier metal layer, and accelerating the removal rate of a wiring metal layer is not described.

Whereas, to prevent scratches on a surface of a copper layer in a process of forming wiring boards by a build-up method, a method of polishing the copper layer by using a backing material that has a prescribed hardness and compressibility, is disclosed (Patent Document 5) .

As disclosed, according to the method, it is possible to increase the removal rate and improve the throughput by using an amino acid as a copper chelating agent and further using a polishing solution that comprises a copper etching agent, a copper oxidizing agent and water. However, to improve the throughput to be comparable to the mechanical polishing, further improvement of the removal rate is required.
Patent Document 1: JP-A-2003-197806
Patent Document 2: JP-A-2001-110761
Patent Document 3: JP-A-2003-286477
Patent Document 4: JP-A-2003-297779
Patent Document 5: JP-A-2003-257910

### DISCLOSURE OF THE INVENTION

### OBJECT TO BE ACCOMPLISHED BY THE INVENTION

The present invention has been made in view of these problems. That is, an object of the present invention is to provide a polishing compound that is capable of minimizing formation of scratches on an object to be polished, such as a resin substrate or a metal wiring, and polishing at a high removal rate. Another object of the present invention is to provide a polishing method that is capable of minimizing formation of scratches on a resin substrate or a metal wiring, and improving the throughput by polishing at a high removal rate.

Other objects and advantages of the present invention will be apparent from the following description.

### MEANS TO ACCOMPLISH THE OBJECT

The present invention provides the following, and the polishing compound of the present invention is particularly preferred for polishing to form metal wirings on a resin substrate provided on a supporting board.
1. A polishing compound comprising abrasive particles, an oxidizing agent, an electrolyte and an aqueous medium, wherein ions formed from the electrolyte comprise ammonium ions, at least one type of organic carboxylate ions selected from the group consisting of polycarboxylate ions and hydroxycarboxylate ions, and at least one type of ions selected from the group consisting of carbonate ions, hydrogencarbonate ions, sulfate ions and acetate ions.
2. The polishing compound according to the above 1, wherein the organic carboxylate ions are polycarboxylate ions.
3. The polishing compound according to the above 1 or 2, wherein the sum of the concentrations of one or more types of ions, which are selected from the group consisting of the carbonate ions, the hydrogencarbonate ions, the sulfate ions and the acetate ions, is from 0.01 mol/kg to 0.3 mol/kg.
4. The polishing compound according to the above 1 or 2, wherein the sum of the concentrations of one or more types of ions, which are selected from the group consisting of the carbonate ions, the hydrogencarbonate ions, the sulfate ions and the acetate ions, is from 0.01 mol/kg to 0.2 mol/kg.
5. The polishing compound according to any one of the above 1 to 4, wherein the concentration of the ammonium ions is at least 0.03 mol/kg.
6. The polishing compound according to any one of the above 1 to 4, wherein the concentration of the ammonium ions is at least 0.3 mol/kg.
7. The polishing compound according to any one of the above 1 to 6, wherein the concentration of the organic carboxylate ions is from 0.02 mol/kg to 0.5 mol/kg.
8. The polishing compound according to any one of the above 1 to 7, wherein the concentration of the organic carboxylate ions is from 0.05 mol/kg to 0.5 mol/kg.
9. The polishing compound according to any one of the above 1 to 8, wherein the electrolyte comprises at least one member selected from the group consisting of ammonia, ammonium carbonate, ammonium hydrogencarbonate, ammonium sulfate, and ammonium acetate.
10. The polishing compound according to any one of the above 1 to 9, wherein the organic carboxylate ions are at least one member selected from the group consisting of citrate ions, oxalate ions, malonate ions, succinate ions, phthalate ions, maleate ions, fumarate ions, lactate ions, glycolate ions, gluconate ions and tartrate ions.
11. The polishing compound according to any one of the above 1 to 10, wherein the abrasive particles are α-alumina.
12. The polishing compound according to any one of the above 1 to 11, wherein the oxidizing agent is hydrogen peroxide.
13. The polishing compound according to any one of the above 1 to 12, which has a pH of 6 to 10.
14. The polishing compound according to any one of the above 1 to 13, which further contains a surface protecting agent for copper.
15. A polishing method comprises polishing a wiring metal by using the polishing compound as defined in any one of the above 1 to 14.
16. The polishing method according to the above 15, wherein the wiring metal is either copper or a copper alloy.

### EFFECTS OF THE INVENTION

According to the polishing compound of the present invention, it is possible to minimize formation of scratches on an object to be polished and to carry out polishing at a high removal rate.

According to the polishing method of the present invention, it is possible to carry out polishing at a high removal rate, while minimizing formation of scratches on a resin substrate or a metal wiring, so that the throughput can be improved.

### BRIEF DESCRIPTION OF THE DRAWINGS

Fig. 1 is a schematic sectional side view showing a resin substrate, which is set up on a supporting board.
Fig. 2 is a schematic sectional side view (before polishing) showing a resin substrate wherein wiring metals are embedded in of its trenches.
Fig. 3 is a schematic sectional side view (after polishing) showing a wiring board produced by the present invention.

### MEANINGS OF SYMBOLS

1 Resin substrate
2 Wiring trench
3 Wiring metal
4 Wiring board
5 Supporting board

### BEST MODE FOR CARRYING OUT THE INVENTION

The polishing compound of the present invention preferably comprises abrasive particles, at least one salt selected from the group consisting of a carbonate, a hydrogencarbonate, a sulfate and an acetate, at least one organic carboxylic acid (hereinafter referred to simply as an organic carboxylic acid) selected from the group consisting of a polycarboxylic acid and a hydroxycarboxylic acid, at least one of ammonia and an ammonium salt, an oxidizing agent and a medium. Here, the polycarboxylic acid is a carboxylic acid having at least two carboxyl groups, which may also have a hydroxyl group. The hydroxycarboxylic acid is a carboxylic acid having at least one carboxyl group and at least one hydroxyl group.

In the present invention, the concentration of at least one type of ions selected from the group consisting of carbonate ions (CO₃²⁻), hydrogencarbonate ions (HCO₃⁻), sulfate ions (SO₄²⁻) and acetate ions (CH₃COO⁻), or the sum of the concentrations of at least two types of ions selected from such a group, is preferably from 0.005 mol/kg to 1.0 mol/kg, and particularly preferably from 0.01 mol/kg to 0.3 mol/kg.

The above-mentioned Patent Documents 3 and 4 describe a polishing compound comprising a polishing agent, an organic acid, hydrogen peroxide, water and an agent for adjusting the removal rate. Here, the agent for adjusting the removal rate is a salt of an inorganic or organic acid with a basic compound, and it is contained at a concentration within a range from 0.001 weight% to 1 weight% in the polishing compound.

According to these Patent Documents, the agent for adjusting a removal rate is to adjust the removal rate of a metal of a wiring metal layer or a barrier metal layer, and it is possible to lower the removal rate of the metal of the wiring metal layer by adjusting its concentration to be within the above range, thereby to raise the polishing selectivity for the metal of the barrier metal layer.

Whereas, as a result of an extensive research, the present inventors have found that the polishing compound of the present invention can accelerate the removal rate of a wiring metal, such as copper. That is, by the polishing compound of the present invention, as is different from Patent Documents 3 and 4, it is possible to accelerate the removal rate of the wiring metal more than ever.

The mechanism is not necessarily apparent. However, a composite complex is formed by ammonium ions, at least one type of ions selected from the group consisting of organic carboxylate ions, carbonate ions, hydrogencarbonate ions, sulfate ions and acetate ions and the wiring metal, such as copper, whereby etching on the wiring metal by chemical action becomes easy.

Further, especially when the concentrations of at least one type of ions selected from the group consisting of carbonate ions, hydrogencarbonate ions, sulfate ions and acetate ions, or the sum of the concentrations of at least two types of ions selected from such a group, is from 0.005 mol/kg to 1.0 mol/kg, preferably from 0.01 mol/kg to 0.3 mol/kg, more preferably from 0.01 mol/kg to 0.2 mol/kg, it is possible to obtain the above effects to the maximum.

Moreover, the above-mentioned Patent Document 5 discloses a polishing solution comprising a copper chelating agent, a copper etching agent, a copper oxidizing agent and water. It discloses that as the etching agent, ammonia or an ammonium salt is preferably used. Particularly, ammonium nitrate (NH₄NO₃), ammonium chloride (NH₄Cl) and ammonium citrate ((NH₄)₂HC₆H₅O-₇) are disclosed as examples as well as ammonium carbonate and ammonium hydrogencarbonate.

The same result as in the present invention would not be achieved unless the carbonate ions, the hydrogencarbonate ions, the sulfate ions, or the acetate ions are contained, even if the polishing compound contains the ammonium ions and the citrate ions as one of the organic carboxylate ions. Therefore, only a polishing compound that has the composition of the present invention can effectively accelerate the removal rate.

The effects of the present invention cannot be achieved even if a polishing compound contains ammonium nitrate, ammonium chloride and ammonium citrate which are disclosed in Patent Document 5, unless it contains at least one type of ions selected from the group consisting of the carbonate ions, the hydrogencarbonate ions, the sulfate ions and the acetate ions, and the organic carboxylate ions at the same time.

In the present invention, the ammonium ions, the organic carboxylate ions, at least one type of ions selected from the group consisting of the carbonate ions, the hydrogencarbonate ions, the sulfate ions and the acetate ions can be formed from the electrolyte contained in the polishing compound.

For example, the electrolyte can produce the ammonium ions when at least one of aqueous ammonia and an ammonium salt is contained. In this case, if the ammonium salt is at least one member selected from the group consisting of ammonium carbonate, ammonium hydrogencarbonate, ammonium sulfate and ammonium acetate, it is possible to produce any one of the carbonate ions, the hydrogencarbonate ions, the sulfate ions and the acetate ions. Further, if the electrolyte contains at least one of citric acid and tartaric acid, it is possible to produce the organic carboxylate ions.

However, the electrolyte is not limited to be such substances as exemplified above, and it may be any electrolyte that is capable of forming the ammonium ions, the organic carboxylate ions and at least one type of ions selected from the group consisting of the carbonate ions, the hydrogencarbonate ions, the sulfate ions, and the acetate ions.

Now, the polishing compound of the present invention will be described in detail with reference to specific embodiments.

The abrasive particles are to carry out the polishing by mechanical function. In general, it is possible to accelerate the removal rate as the particle size and stiffness of the abrasive particles increase. However, scratches tend to be easily formed on the surface polished at the same time. Accordingly, it is important to choose abrasive particles having proper particle size and stiffness in consideration of the removal rate and polishing scratches.

In the present invention, the object to be polished is a wiring metal such as copper formed on a resin substrate. Therefore, as is different from a case of polishing a semiconductor board, it is possible to select the abrasive particles with a preference for the improvement of the removal rate over the suppression of polishing scratches. Further, as compared to a case of polishing a semiconductor board, it is preferred in the present invention that the average particle size of the abrasive particles is large. Furthermore, the abrasive particles are preferably hard.

Even under these conditions, in the present invention, the polishing is carried out by a combination of mechanical action and chemical action, whereby it is possible to minimize formation of scratches on the object polished as compared to the polishing by only mechanical action.

As abrasive particles in the present invention, for example, an aluminum oxide, such as α-alumina (α-Al₂O₃), β-alumina (β-Al₂O₃), δ-alumina (δ-Al₂O₃), γ-alumina (γ-Al₂O₃) or θ-alumina (θ-Al₂O₃); cerium oxide (CeO₂); silicon dioxide (SiO₂); titanium oxide (TiO₂); zirconium oxide (ZrO₂) may be used. However, these abrasive particles are used not only individually but also in combination as a mixture of at least two types.

In the present invention, α-alumina is particularly preferred from the viewpoint of low-cost and capability of accelerating the removal rate. For example, it is possible to use α-alumina having an average particle size of about 1µm at a concentration of preferably from 0.05 weight% to 5.0 weight%, more preferably from 0.1 weight% to 3.0 weight%.

In the polishing compound, the abrasive particles exist as dispersed in an aqueous medium. As the aqueous medium, for example, highly purified water such as ion-exchanged water, or a one comprising a water-soluble organic solvent and water as the main component, may be used. Here, as the organic solvent, a lower alcohol having from 1 to 5 carbon atoms such as methanol, ethanol, propanol, butanol or ethylene glycol may be mentioned.

In the present invention, it is possible to accelerate the polishing by adding an oxidizing agent in the polishing compound. Specifically, by a function of the oxidizing agent, an oxide film will be formed on the surface of a wiring metal as an object to be polished. Then, the oxide film is removed from the surface of a resin substrate by a mechanical power or by the function of the oxidizing agent, the wiring metal becomes ions and dissolves in the polishing compound, whereby the polishing will be accelerated.

In the present invention, the concentration of the oxidizing agent in the polishing compound is preferably in a range of from 0.1 mol/kg to 10 mol/kg, more preferably from 0.1 mol/kg to 5 mol/kg, particularly preferably from 0.1 mol/kg to 2 mol/kg.

As the oxidizing agent, hydrogen peroxide, urea hydrogen peroxide, acetyl hydroperoxide, ferric nitrate or an iodate may, for example, be used. Particularly, it is preferred to use hydrogen peroxide, whereby contamination of a wiring board caused by a heavy metal or an organic substance, can be minimized.

As mentioned above, the polishing compound of the present invention is characterized by comprising at least one type of ions selected from the group consisting of the carbonate ions, the hydrogencarbonate ions, the sulfate ions and the acetate ions. Particularly, in the present invention, these ions play an effective role for accelerating the removal rate of the wiring metal.

In the present invention, by using any type of ions selected from the carbonate ions, the hydrogencarbonate ions, the sulfate ions and the acetate ions, it is possible to obtain the specific effect to accelerate the removal rate of the wiring metal.

In the present invention, one or more members selected from the group consisting of the carbonate ions, the hydrogencarbonate ions, the sulfate ions and the acetate ions, are contained in the polishing compound at a concentration of preferably from 0.005 mol/kg to 1.0 mol/kg, more preferably from 0.01 mol/kg to 0.3 mol/kg, particularly preferably from 0.01 mol/kg to 0.2 mol/kg, irrespective of the valence. If the concentration becomes lower than 0.005 mol/kg, the effects of the present invention will not be obtained. On the other hand, if the concentration becomes higher than 1.0 mol/kg, the viscosity tends to increase and the polishing property will be deteriorated.

Further, each type of ions can individually be at a concentration within the above range. When at least two types of ions are contained in combination in the polishing compound, the sum of the respective types of ions may be at a concentration within the above range. Further, the concentration of ions does not depend on the valence of ions. For example, the polishing compound can contain either the carbonate ions or the hydrogencarbonate ions at a concentration within the above range. Otherwise, the polishing compound can contain both of the carbonate ions and the hydrogencarbonate ions. In this case, the sum of the concentration of the carbonate ions and the hydrogencarbonate ions is within the above range.

In the present invention, the carbonate ions, the hydrogencarbonate ions, the sulfate ions and the acetate ions can be used in the form of an ammonium salt, such as ammonium carbonate ((NH₄)₂CO₃), ammonium hydrogencarbonate (NH₄HCO₃), ammonium sulfate ((NH₄)₂SO₄) or ammonium acetate (CH₃COONH₄). However, they are not limited to an ammonium salt, but may be other basic compounds, such as a sodium salt and a potassium salt.

In general, ammonium ions play a role of chemically etching a wiring metal as an object to be polished. For example, if the wiring metal is copper, the ammonium ions chemically etch the copper by forming a complex with the copper.

Particularly, in the present invention, the ammonium ions are considered to work together with the organic carboxylate ions or above-mentioned carbonate ions to form a composite complex with a wiring metal. This is considered to make the etching of a wiring metal easier. The ammonium ions are contained in the polishing compound preferably at a concentration of more than 0.1 mol/kg, more preferably more than 0.3 mol/kg. If the concentration becomes lower than 0.1 mol/kg, the effects of the present invention will not be obtained.

Further, it is preferred that the concentration of the ammonium ions is at most 1.5 mol/kg, and at the same time, the polishing compound of the present invention is within the after-mentioned pH range. If the concentration of the ammonium ions is more than 1.5 mol/kg, the pH stability of the polishing compound of the present invention may be lowered.

When copper wirings are to be formed in an interlayer insulating film on a semiconductor board, it is necessary to form a diffusion barrier film such as tantalum (Ta) film or tantalum nitride (TaN) film for preventing diffusion of the copper. In this case, if the concentration of the ammonium ions becomes high, the removal rate of the tantalum will be accelerated, and the polishing selectivity for copper will become low. Therefore, the ammonium ions need to be at a concentration where the removal rate of the tantalum will not be too high.

On the other hand, in a process for producing a wiring board, because no diffusion barrier film is formed, it is not necessary to consider the above problem. Therefore, within a range not to deteriorate other properties, it is possible to incorporate more ammonium ions as compared to the case where a diffusion barrier film is formed.

In the present invention, as a source for the ammonium ions, inexpensive aqueous ammonia is particularly preferably used. Further, a part of it may be supplied by adding the carbonate ions, the hydrogencarbonate ions, the sulfate ions or the acetate ions in the form of an ammonium salt.

In the polishing compound of the present invention, the organic carboxylate ions are considered to form a composite complex with a wiring metal together with the ammonium ions or the above mentioned carbonate ions, whereby etching of the wiring metal is considered to be facilitated.

Further, the organic carboxylate ions are effective for preventing problems of dishing and erosion. Here, the dishing means a condition that when forming a metal-embedded wiring, a center portion of the wiring becomes caved as a result of excessive polishing at a wide portion of the wiring.

Whereas, the erosion is a phenomenon such that a portion where wiring density is high, is excessively polished as compared to a low-density portion, and as a result an insulating film becomes thin at the portion where the wiring density is high. By incorporating the organic carboxylate ions to the polishing compound, it is possible to prevent these problems.

The organic carboxylate ions may, for example, be citrate ions (C₃H₄(OH)(COO)₃³⁻), oxalate ions ((COO)₂²⁻), malonate ions (CH₂(COO)₂²⁻), succinate ions (C₂H₄(COO)₂²⁻), phthalate ions (C₆H₄(COO)₂²⁻) maleate ions (C₂H₂(COO)₂²⁻) fumarate ions (C₂H₂(COO)₂²⁻) lactate ions (CH₃CH(OH)COO⁻), glycolate ions (CH₂(OH)COO⁻), gluconate ions (CH₂(OH) (CH(OH))₄COO⁻) or tartrate ions (C₂H₂(OH)₂(COO)₂²⁻). It is also acceptable to use malate ions (C₂H₃(OH) (COO)₂²⁻), glutarate ions ((CH₂)₃(COO)₂²⁻) or adipate ions ((CH₂)₄(COO)₂²⁻). From the viewpoint of low-cost, citrate ions are preferably used. Further, the above-exemplified ions can be used individually or in a combination of two or more types of them. Moreover, the polycarboxylate ions may exist in the form of ions bonded with hydrogen ions in an aqueous solution, like hydrogen citrate ions (C₃H₄(OH) (COOH) (COO) ₂²⁻) or di-hydrogen citrate ions (C₃H₄(OH)(COOH)₂(COO)⁻) in the case of citrate ions. In the present specification, the concentration of the polycarboxylate ions means the concentration that includes such ions bonded with hydrogen ions. Also, the concentration of the multivalent inorganic acid ions, such as carbonate ions and sulfaric ions, means the concentration that includes such ions bonded with hydrogen ions, such as hydrogencarbonate ions and hydrogensulfate ions.

As the above phthalate ions, 1,2-phthalate ions are preferably used.

In the polishing compound of the present invention, the organic carboxylate ions are, irrespective of the valence, contained at a concentration of preferably at least 0.01 mol/kg, more preferably from 0.02 mol/kg to 0.5 mol/kg, particularly preferably from 0.05 mol/kg to 0.5 mol/kg. If the concentration of the organic carboxylate ions becomes lower than 0.01 mol/kg, the effects of the present inventions will not be obtained. On the other hand, if the concentration of the organic carboxylate ions becomes higher than 0.5 mol/kg, the removal rate will no more be accelerated.

Further, the polishing compound of the present invention preferably contains a surface protective agent which has a function to form a protective film on the surface of a wiring metal (particularly, copper or copper alloy), to prevent the dishing of the wiring metal portion.

The surface protective agent may, for example, be BTA (benzotriazole), TTA (tolyl triazole) or benzotriazole-4-carboxylic acid. Further, 1H-tetrazole, 5-amino-1H-tetrazole, 5-methyltetrazole, thiourea, salicylaldoxime or catechol may also be used. For example, when the wiring metal is copper, these substances may be physically and chemically adsorbed thereon to form a coating on the surface of the copper thereby to suppress copper elution. Moreover, the above substances can be used individually or in a combination of two or more of them.

In a case where BTA is used as the surface protective agent, BTA is contained in the polishing compound at a concentration of preferably from 0.0005 mol/kg to 0.5 mol/kg, more preferably from 0.0007 mol/kg to 0.02 mol/kg, particularly preferably from 0.001 mol/kg to 0.02 mol/kg. If the concentration is less than 0.0005 mol/kg, the effects of the surface protective agent will not be obtained. On the other hand, if the concentration becomes higher than 0.05 mol/kg, the removal rate will be decreased such being undesirable.

Further, the polishing compound of the present invention may contain a chelating agent. For example, when a wiring metal as an object to be polished is copper, it is preferred to add a chelating agent that shows a chelating function to copper.

In a polishing process, a part of polished wiring metal becomes ionized and dissolves in the polishing solution, and if metal ions exist in the polishing solution, they act as a catalyst to possibly decompose an oxidizing agent or cause a runaway oxidation reaction. If this decomposition of the oxidizing agent or runaway of oxidation reaction happens, roughness will be formed on the surface of the wiring metal. Further, excess etching of the wiring metal may take place to cause dishing.

When the chelating agent is contained in the polishing compound, dissolved metal ions will be stabilized and the above abnormal reaction will be suppressed, and thus, it is possible to improve the finish after the polishing. Therefore, it is preferred to have the chelating agent added in the polishing compound.

The chelating agent may, for example, be ethylenediamine, diethylenetriamine, triethylenetetramine, tetraethylenepentamine, pentaethylenehexamine (PEHA), ethylenediaminetetraacetic acid, diethylenetriaminepentaacetic acid, triethylenetetraminehexaacetic acid or nitrilotriacetic acid.

If the concentration of the chelating agent is too low, the effect for suppressing the above abnormal reaction may not be sufficiently seen. On the other hand, if the concentration of the chelating agent is too high, the removal rate may be decreased. For example, in a case of using pentaethylenehexamine as the chelating agent, it is contained in the polishing compound at a concentration of preferably from 0.0003 mol/kg to 0.05 mol/kg, more preferably from 0.0005 mol/kg to 0.03 mol/kg, particularly preferably from 0.001 mol/kg to 0.01 mol/kg.

Further, the polishing compound of the present invention may contain a pH adjusting agent or a surfactant if necessary.

In order to preventing copper as an object to be polished, from being oxidized, the pH of the polishing compound is preferably inclined toward the basic side. Specifically, the pH is within a range of preferably from 6 to 10, particularly preferably from 7 to 10.

In the present invention, the pH may be adjusted by the amounts of the acid and ammonium ions to be incorporated in the polishing compound, but it is also possible to adjust the pH by adding a pH adjusting agent. In this case, the amount of the pH adjusting agent is not limited as long as it does not impair the polishing performance.

As the pH adjusting agent, a suitable acid or alkali may be used, but it is required to be such that the concentration of the carbonate ions, the hydrogencarbonate ions, the sulfate ions, the acetate ions or the ammonium ions in the polishing compound, should not depart from the range specified by the present invention.

For example, as the pH adjusting agent to adjust the pH toward the acidic side, nitric acid may, for example, be used and to adjust the pH toward the basic side, an alkali metal compound such as potassium hydroxide may, for example, be used.

The surfactant may be used to improve dispersibility of the polishing compound or to prevent roughening of the surface of the wiring metal after the polishing. In the present invention, any of an anionic surfactant, a cationic surfactant, a nonionic surfactant or an amphoteric surfactant may be used.

However, it is required to be such that the concentration of the carbonate ions, the hydrogencarbonate ions, the sulfate ions, the acetate ions or the ammonium ions in the polishing compound, should not depart from the range specified by the present invention.

For example, it is possible to use an anionic surfactant such as polyacryl acid or an alkylbenzenesulfonate; a nonionic surfactant such as a polyoxyethylene derivative, a polyoxyethylene sorbitan fatty acid ester or a glycerol fatty acid ester; or an amphoteric surfactant such as an alkylbetain.

Now, the polishing method using the polishing compound of the present invention will be described.

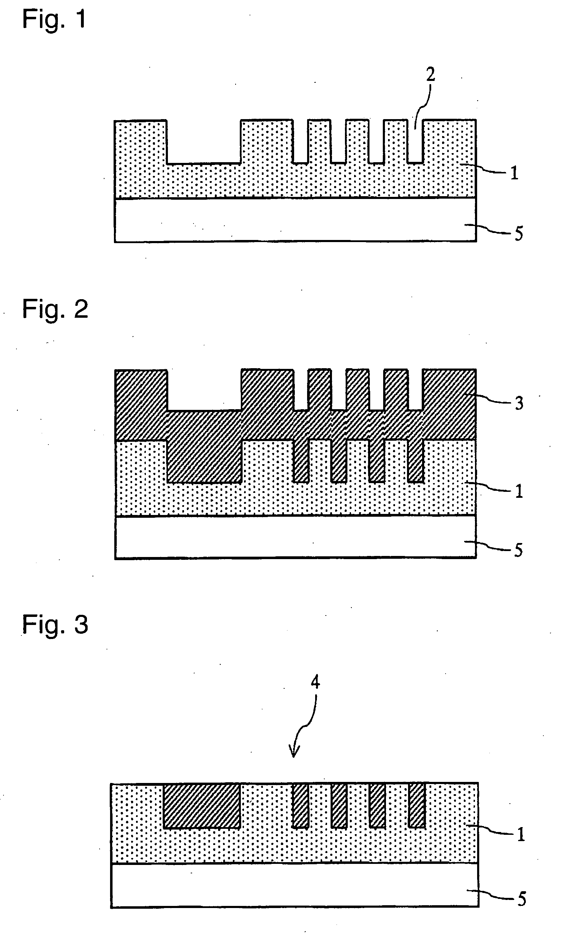

Figs. 1 to 3 show an example for producing a wiring board by using the polishing compound of the present invention. Further, portions identified by the same symbols mean the same portions.

As shown in Fig. 1, by using a laser beam machine, a wiring trench 2 as an opening portion is formed at a prescribed place on a resin substrate 1 which is provided on top of a supporting board 5.

The resin substrate 1 is made of an insulating material that preferably consists of a thermoplastic resin, a thermosetting resin or a mixture of them. Particularly, it is possible to use a thermoplastic resin having a relatively high heat resistance such as PEEK (polyetherether ketone), PEK (polyether ketone), PEI (a polyetherimide), a polyimide or PPS (polyphenylene sulfide); a thermosetting resin such as a polyester, an epoxy resin, a polyurethane, a phenolic resin or an acrylic resin; or a mixture obtained by mixing the above thermoplastic resin into the thermosetting resin such as glass epoxy prepreg material such as a FR4 or FR5. Here, although the thickness of the substrate is not particularly limited, it may, for example, be a film having a thickness of from 50 µm to 200 µm.

Then, as Fig. 2 shows, a wiring metal 3 is embedded in the wiring trench 2. In the present invention, copper is preferably used as the wiring metal 3. Embedding copper is carried out, for example, by forming a copper film as a seed copper by a sputtering method, followed by plating.

In Fig. 2, unevennesses are formed by the wiring metal 3 on the resin substrate 1. Therefore, by the polishing using the polishing compound of the present invention, an excessive amount of the wiring metal 3 on the resin substrate 1 is removed.

In polishing process, the object to be polished is the wiring metal 3, so the polishing amount depends on the film thickness of the wiring metal 3. Therefore, to improve the throughput, it is important to accelerate the removal rate of the wiring metal 3.

Further, in general, in processes for producing a wiring board, a demand for flatness of the surface of the board will be lower as compared to the case for forming multiplayer wirings on a semiconductor board. Consequently it is not necessary to carry out a two-step polishing wherein, for example, the most part of the wiring metal is removed first at a high removal rate, and then the polishing condition will be changed to remove the rest of the wiring metal, and it is possible to remove the wiring metal in one step polishing without changing the condition.

In the present invention, the polishing method is not particularly limited. For example, while holding the back of a supporting board with a rotatable polishing head and pressing the surface to be polished (the side where the wiring metal is formed) to a polishing pad fixed to a rotatable support, it is possible to carry out the polishing by rotating the polishing head and the support. Otherwise, by fixing the back of the supporting board on the rotatable support, and pressing the polishing pad attached to the polishing head, to the surface to be polished, it is possible to carry out the polishing by rotating the polishing head and the support.

In these cases, the polishing is carried out by supplying the polishing compound of the present invention between the surface to be polished and the polishing pad.

Further, it is possible to carry out the polishing by using a cushioning material between the support and the supporting board to relief the pressure exerted on the supporting board during the polishing, and to exert the pressure uniformly on the surface to be polished. Further, channels or feed orifices may be provided in the polishing pad to supply the polishing compound uniformly to the surface to be polished.

The material for the polishing pad, may, for example, be polyester or polyurethane. However, it is not limited thereto, but it may be suitably selected for use depending on the polishing compound to be used.

In general, if the polishing pressure is increased, it is possible to accelerate the removal rate, but damage on the object to be polished will be greater. For example, in a case of polishing an insulating film, which is formed on a semiconductor board, if the polishing pressure becomes high, the insulating film will have a greater risk of being separated from the semiconductor board. Therefore, it is important to determine the polishing pressure in consideration and comparison of mainly the removal rate and the damage that it may cause to the object to be polished.

In the present invention, the wiring metal such as copper is the object to be polished. Therefore, as compared to the case of polishing an insulating film, it is possible to determine the polishing pressure giving a priority to improvement of the removal rate. Further, even under such a condition, in the present invention, the polishing is carried out by both mechanical and chemical actions, whereby it is possible to minimize formation of scratches as compared to the polishing carried out by only a mechanical action.

Thus, according to the polishing compound of the present invention, it is possible to obtain a high removal rate even if the polishing pressure is low. Moreover, by increasing the polishing pressure, it is possible to accelerate the removal rate more. Further, in this case, it is preferred to set a specific polishing pressure depending upon the type of the polishing pad, the presence or absence of a cushion material as well as its material, and the viscosity of the polishing compound.

Upon completion of the polishing, a wiring board 4 having a structure of Fig. 3 will be obtained. Then, it is preferred to wash the wiring board 4 to remove components of the polishing agent adsorbed on its surface. Other than the washing by running water, the washing can be carried out by scrub washing by a brush or ultrasonic cleaning.

As mentioned above, according to the polishing compound of the present invention, the polishing is carried out by both chemical and mechanical actions, and it is possible to minimize formation of scratches on a resin substrate and a wiring metal. Further, it is also possible to accelerate the removal rate of the wiring metal, and thus it is possible to improve the throughput in the process for producing a wiring board. In other words, according to the polishing compound of the present composition, it is possible to accomplish a removal rate comparable to a mechanical polishing, while minimizing formation of scratches on the resin substrate or wiring metal.

Further, the present invention is not limited to the above embodiments, but various modifications may be made without departing from the scope of the present invention.

Now, Examples of the present invention will be described.

### EXAMPLES

### First Examples

### Polishing Compounds

As polishing compounds, those shown in a Table 1 were used. Examples 1 to 13 are Examples of the present invention, and Examples 14 to 18 are Comparative Examples. Further, "carbonate ions and hydrogencarbonate ions" are shown by the sum of the concentrations of the respective ions. As the α-alumina, "α-alumina 1 µm" (the average particle size is 1 µm) manufactured by Wako Pure Chemical Industries, Ltd, was used.

### Object to Be Polished

As the supporting board, a metal wafer having a thickness of 500 µm and a diameter of 6 inches was used, and on the wafer, a resin substrate having a thickness of 50µm was laminated. Then, by plating, a copper film having a thickness of 30 µm was formed thereon.

### Polishing Conditions

The polishing was carried out under the following conditions.

Polishing machine: Polishing machine 6EC, manufactured by Strasbaugh
Polishing pad: IC-1400 K-Groove, manufactured by Rodel, Inc.
Polishing compound supply amount: 200 mL/min
Polishing pressure: 4.1×10⁴ Pa (2.7×10⁴ Pa only in Example 18)
Number of revolutions of polishing pad: Polishing head (wafer holding portion) 97 rpm, platen (polishing platen) 103 rpm

Table 2 shows results of measurements of the removal rates. Here, the removal rate was obtained by measuring the film thickness of a copper film before and after the polishing by a film thickness measuring apparatus (RT80-RG80, manufactured by Napson Corporation).

### First Comparative Examples

The polishing was carried out in the same manner as in Examples by using a polishing compound comprising chloride ions, nitrate ions or thiosulfate ions as shown in Table 3 instead of the carbonate ions, hydrogencarbonate ions, sulfate ions or acetate ions used in Examples.

Table 4 shows the results of measurements of the removal rates. The removal rate was obtained in the same manner in Examples.

### Second Examples

### Polishing Compounds

As polishing compounds, those shown in Table 5 were used. Examples 19 to 36, Examples 41 to 43 and Examples 45 to 50 are Examples of the present invention, and Examples 37 to 40 and Example 44 are Comparative Examples. As the α-alumina, TAIMICRON TM-D manufactured by TAIMEI Chemicals Co., Ltd was used.

### Object to Be Polished

A square chip of 45x45 mm, prepared by cutting a Blanket copper wafer for a CMP testing, manufactured by Advanced Technology Development Facility, Inc. (Model No.000CUR071: one obtained by forming a thermally oxidized film having a thickness of 0.3 µm on a Si wafer having a diameter of 8 inches, and forming thereon a Ta film having a thickness of 50 nm by CVD and a copper film having a thickness of 100 nm by CVD, and a copper film having a thickness of 1.5 µm by plating).

### Polishing Conditions

The polishing was carried out under the following conditions.

Polishing machine: A small-sized desktop lapping machine NF-300, manufactured by Nano Factor Co., Ltd.
Polishing pad: IC-1000 K-Groove, manufactured by Rodel, Inc.
Polishing compound supply amount: 30 mL/min
Polishing pressure: 2.8×10⁴ Pa (calculated from the weight of the polishing head and the pressure of nitrogen used for pressing)
Number of revolutions of polishing pad: Polishing head (a wafer holding portion) 50 rpm, platen (polishing platen) 60 rpm

Table 6 shows results of measurements of the removal rates. Here, the removal rate was obtained by polishing an object to be polished for 15 to 30 seconds under the above conditions, and measuring the thickness of a copper film before and after the polishing by a film thickness measuring apparatus (RS80 manufactured by KLA-Tencor Corporation), then calculating the polishing amount per 60 seconds from changes in the film thickness.

**TABLE 1**

| | α-alumina mass% | Hydrogen peroxide mol/kg | Ammonium ions mol/kg | Citric acid mol/kg | Carbonate ions and hydrogen-carbonate ions mol/kg | Sulfate ions mol/kg | Acetate ions mol/kg | BTA mol/kg | PEHA mol/kg | Potassium ions mol/kg | Water | pH |
|---|---|---|---|---|---|---|---|---|---|---|---|---|
| Ex.1 | 2.77 | 0.68 | 0.83 | 0.22 | 0.13 | 0.00 | 0.00 | 0.0077 | 0.0018 | 0.00 | Rest | 8 |
| Ex.2 | 2.77 | 0.68 | 0.73 | 0.22 | 0.04 | 0.00 | 0.00 | 0.0039 | 0.0018 | 0.00 | Rest | 8 |
| Ex.3 | 2.77 | 0.68 | 0.83 | 0.22 | 0.13 | 0.00 | 0.00 | 0.0077 | 0.0018 | 0.00 | Rest | 8 |
| Ex.4 | 2.77 | 0.68 | 0.66 | 0.22 | 0.04 | 0.00 | 0.00 | 0.0039 | 0.0018 | 0.00 | Rest | 8 |
| Ex.5 | 2.77 | 0.68 | 0.70 | 0.22 | 0.04 | 0.00 | 0.00 | 0.0077 | 0.0036 | 0.00 | Rest | 8 |
| Ex.6 | 2.77 | 0.68 | 0.73 | 0.22 | 0.06 | 0.00 | 0.00 | 0.0039 | 0.0018 | 0.00 | Rest | 8 |
| Ex.7 | 2.77 | 0.68 | 0.78 | 0.22 | 0.11 | 0.00 | 0.00 | 0.0039 | 0.0018 | 0.00 | Rest | 8 |
| Ex.8 | 2.77 | 0.68 | 0.99 | 0.22 | 0.00 | 0.14 | 0.00 | 0.0077 | 0.0036 | 0.00 | Rest | 8 |
| Ex.9 | 2.77 | 0.68 | 0.83 | 0.22 | 0.00 | 0.00 | 0.11 | 0.0077 | 0.0036 | 0.00 | Rest | 8 |
| Ex.10 | 2.77 | 0.68 | 0.68 | 0.22 | 0.07 | 0.00 | 0.00 | 0.0077 | 0.0036 | 0.13 | Rest | 8 |
| Ex.11 | 2.77 | 0.68 | 0.68 | 0.22 | 0.02 | 0.00 | 0.00 | 0.0077 | 0.0036 | 0.04 | Rest | 8 |
| Ex.12 | 2.77 | 0.68 | 0.74 | 0.22 | 0.06 | 0.00 | 0.00 | 0.0077 | 0.0072 | 0.00 | Rest | 8 |
| Ex.13 | 2.77 | 0.68 | 0.75 | 0.22 | 0.06 | 0.00 | 0.00 | 0.0116 | 0.0036 | 0.00 | Rest | 8 |

**TABLE 2**

| | Removal rate (µm/min) |
|---|---|
| Example 1 | 7.21 |
| Example 2 | 7.80 |
| Example 3 | 6.60 |
| Example 4 | 8.08 |
| Example 5 | 7.08 |
| Example 6 | 8.20 |
| Example 7 | 7.84 |
| Example 8 | 6.22 |
| Example 9 | 6.60 |
| Example 10 | 7.46 |
| Example 11 | 6.06 |
| Example 12 | 7.08 |
| Example 13 | 5.98 |

**TABLE 3**

| | α-alumina mass% | Hydrogen peroxide mol/kg | Ammonium ions mol/kg | Citric acid mol/kg | Chloride ions mol/kg | Nitrate ions mol/kg | Thio-sulfate ions mol/kg | BTA mol/kg | PEHA mol/kg | Potassium ions mol/kg | Water | pH |
|---|---|---|---|---|---|---|---|---|---|---|---|---|
| Ex.14 | 2.57 | 1.26 | 0.89 | 0.20 | 0.24 | 0.00 | 0.00 | 0.0072 | 0.0033 | 0.00 | Rest | 8 |
| Ex.15 | 2.57 | 1.26 | 0.90 | 0.20 | 0.00 | 0.24 | 0.00 | 0.0072 | 0.0033 | 0.00 | Rest | 8 |
| Ex.16 | 2.77 | 0.68 | 1.00 | 0.22 | 0.26 | 0.00 | 0.00 | 0.0077 | 0.0036 | 0.00 | Rest | 8 |
| Ex.17 | 2.77 | 0.68 | 0.78 | 0.22 | 0.00 | 0.00 | 0.06 | 0.0077 | 0.0036 | 0.00 | Rest | 8 |
| Ex.18 | 2.77 | 0.68 | 0.63 | 0.00 | 0.52 | 0.00 | 0.00 | 0.0000 | 0.0000 | 0.00 | Rest | 9 |

**TABLE 4**

| | Removal rate (µm/min) |
|---|---|
| Example 14 | 3.40 |
| Example 15 | 2.73 |
| Example 16 | 2.86 |
| Example 17 | 4.82 |
| Example 18 | 2.55 |

**TABLE 5**

| | α-alumina mass% | Hydrogen peroxide mol/kg | Ammonium ions mol/kg | Organic carboxylate ions mol/kg | | Carbonate ions and hydrogen-carbonate ions mol/kg | Sulfate ions mol/kg | Acetate ions mol/kg | BTA mol/kg | PEHA mol/kg | Water | pH |
|---|---|---|---|---|---|---|---|---|---|---|---|---|
| Ex.19 | 0.92 | 0.68 | 0.12 | Citric acid | 0.02 | 0.06 | 0.00 | 0.00 | 0.0008 | 0.0004 | Rest | 8.2 |
| Ex.20 | 0.92 | 0.68 | 0.49 | Citric acid | 0.14 | 0.04 | 0.00 | 0.00 | 0.0008 | 0.0004 | Rest | 8.1 |
| Ex.21 | 0.92 | 0.68 | 1.10 | Citric acid | 0.34 | 0.04 | 0.00 | 0.00 | 0.0008 | 0.0004 | Rest | 8.1 |
| Ex.22 | 0.92 | 0.68 | 1.11 | Citric acid | 0.22 | 0.00 | 0.21 | 0.00 | 0.0008 | 0.0004 | Rest | 8.1 |
| Ex.23 | 0.92 | 0.68 | 0.13 | Oxalic acid | 0.04 | 0.06 | 0.00 | 0.00 | 0.0008 | 0.0004 | Rest | 8.2 |
| Ex.24 | 0.92 | 0.68 | 0.55 | Oxalic acid | 0.25 | 0.04 | 0.00 | 0.00 | 0.0008 | 0.0004 | Rest | 8.1 |
| Ex.25 | 0.92 | 0.68 | 1.15 | Citric acid+ Oxalic acid | 0.11 +0.37 | 0.03 | 0.00 | 0.00 | 0.0008 | 0.0004 | Rest | 8.1 |
| Ex.26 | 0.92 | 0.68 | 1.19 | Citric acid+ Oxalic acid | 0.22 +0.22 | 0.03 | 0.00 | 0.00 | 0.0008 | 0.0004 | Rest | 8.1 |
| Ex.27 | 0.92 | 0.68 | 0.52 | Malonic acid | 0.22 | 0.06 | 0.00 | 0.00 | 0.0008 | 0.0004 | Rest | 8.0 |
| Ex.28 | 0.92 | 0.68 | 0.53 | Succinic acid | 0.22 | 0.06 | 0.00 | 0.00 | 0.0008 | 0.0004 | Rest | 8.0 |
| Ex.29 | 0.92 | 0.68 | 0.55 | Phthalic acid | 0.22 | 0.06 | 0.00 | 0.00 | 0.0008 | 0.0004 | Rest | 8.1 |
| Ex.30 | 0.92 | 0.68 | 0.52 | Maleic acid | 0.22 | 0.06 | 0.00 | 0.00 | 0.0008 | 0.0004 | Rest | 8.2 |
| Ex.31 | 0.92 | 0.68 | 0.53 | Fumaric | 0.22 | 0.06 | 0.00 | 0.00 | 0.0008 | 0.0004 | Rest | 8.1 |
| Ex.32 | 0.92 | 0.68 | 0.32 | acid | 0.31 | 0.06 | 0.00 | 0.00 | 0.0008 | 0.0004 | Rest | 8.0 |
| Ex.33 | 0.92 | 0.68 | 0.42 | Glycolic acid | 0.36 | 0.06 | 0.00 | 0.00 | 0.0008 | 0.0004 | Rest | 7.9 |
| Ex.34 | 0.92 | 0.68 | 0.30 | Gluconic | 0.24 | 0.06 | 0.00 | 0.00 | 0.0008 | 0.0004 | Rest | 8.3 |
| Ex.35 | 0.92 | 0.68 | 0.43 | Tartaric acid | 0.18 | 0.06 | 0.00 | 0.00 | 0.0008 | 0.0004 | Rest | 8.1 |
| Ex.36 | 0.92 | 0.68 | 0.70 | Tartaric acid | 0.31 | 0.06 | 0.00 | 0.00 | 0.0008 | 0.0004 | Rest | 8.2 |
| Ex.37 | 0.92 | 0.68 | 0.68 | Citric acid | 0.22 | 0.00 | 0.00 | 0.00 | 0.0008 | 0.0004 | Rest | 8.0 |
| Ex.38 | 0.92 | 0.68 | 0.43 | Nil | 0.00 | 0.00 | 0.21 | 0.00 | 0.0008 | 0.0004 | Rest | 8.1 |
| Ex.39 | 0.92 | 0.68 | 0.43 | Nil | 0.00 | 0.06 | 0.21 | 0.00 | 0.0008 | 0.0004 | Rest | 8.1 |
| Ex.40 | 0.92 | 0.68 | 0.28 | Nil | 0.00 | 0.06 | 0.00 | 0.22 | 0.0008 | 0.0004 | Rest | 8.1 |

**TABLE 6**

| | Removal rate (µm/min) |
|---|---|
| Example 19 | 0.51 |
| Example 20 | 1.34 |
| Example 21 | 1.47 |
| Example 22 | 1.39 |
| Example 23 | 0.42 |
| Example 24 | 2.81 |
| Example 25 | 4.62 |
| Example 26 | 2.20 |
| Example 27 | 1.52 |
| Example 28 | 0.33 |
| Example 29 | 0.29 |
| Example 30 | 0.88 |
| Example 31 | 0.44 |
| Example 32 | 0.52 |
| Example 33 | 1.15 |
| Example 34 | 0.66 |
| Example 35 | 1.04 |
| Example 36 | 1.36 |
| Example 37 | 1.04 |
| Example 38 | 0.06 |
| Example 39 | 0.26 |
| Example 40 | 0.23 |

**TABLE 7**

| | α-alumina mass% | Hydrogen peroxide mol/kg | Ammonium ions mol/kg | Citrate ions mol/kg | Carbonate ions and hydrogen- carbonate ions mol/kg | Potassium ions mol/kg | BTA mol/kg | PEHA mol/kg | Water | pH |
|---|---|---|---|---|---|---|---|---|---|---|
| Ex.41 | 4.62 | 0.68 | 0.73 | 0.22 | 0.06 | | 0.0008 | 0.0004 | Rest | 8.1 |
| Ex.42 | 0.92 | 0.68 | 0.75 | 0.22 | 0.06 | | 0.0008 | 0.0004 | Rest | 8.1 |
| Ex.43 | 0.09 | 0.68 | 0.73 | 0.22 | 0.06 | | 0.0008 | 0.0004 | Rest | 8.0 |
| EX.44 | 0.92 | 0.68 | 0.00 | 0.22 | 0.06 | 0.77 | 0.0008 | 0.0004 | Rest | 8.0 |
| Ex.45 | 0.92 | 0.68 | 0.03 | 0.22 | 0.03 | 0.65 | 0.0008 | 0.0004 | Rest | 8.1 |
| Ex.46 | 0.92 | 0.68 | 0.06 | 0.22 | 0.06 | 0.65 | 0.0008 | 0.0004 | Rest | 8.1 |
| Ex.47 | 0.92 | 0.68 | 0.17 | 0.22 | 0.06 | 0.54 | 0.0008 | 0.0004 | Rest | 8.0 |
| Ex.48 | 0.92 | 0.68 | 0.33 | 0.22 | 0.06 | 0.40 | 0.0008 | 0.0004 | Rest | 8.3 |
| Ex.49 | 0.92 | 0.68 | 0.60 | 0.22 | 0.06 | 0.13 | 0.0008 | 0.0004 | Rest | 8.0 |
| Ex.50 | 0.92 | 0.68 | 0.75 | 0.22 | 0.06 | 0.00 | 0.0008 | 0.0004 | Rest | 8.1 |

**TABLE 8**

| | Removal rate (µm/min) |
|---|---|
| Example 41 | 1.99 |
| Example 42 | 1.82 |
| Example 43 | 0.96 |
| Example 44 | 0.25 |
| Example 45 | 0.38 |
| Example 46 | 0.56 |
| Example 47 | 0.85 |
| Example 48 | 1.33 |
| Example 49 | 1.57 |
| Example 50 | 1.82 |

### INDUSTRIAL APPLICABILITY

The polishing method using the polishing composition of the present invention is able to carry out polishing at a high removal rate, while minimizing formation of scratches on a resin substrate and a metal wiring, so that the throughput can be improved. Thus, it is extremely useful for industrial applications.

The entire disclosure of Japanese Patent Application No. 2005-226177 filed on August 4, 2005 including specification, claims, drawings and summary is incorporated herein by reference in its entirety.

## Claims

1. A polishing compound comprising abrasive particles, an oxidizing agent, an electrolyte and an aqueous medium, wherein ions formed from the electrolyte comprise ammonium ions, at least one type of organic carboxylate ions selected from the group consisting of polycarboxylate ions and hydroxycarboxylate ions, and at least one type of ions selected from the group consisting of carbonate ions, hydrogencarbonate ions, sulfate ions and acetate ions.

2. The polishing compound according to Claim 1, wherein the organic carboxylate ions are polycarboxylate ions.

3. The polishing compound according to Claim 1 or 2, wherein the sum of the concentrations of one or more types of ions, which are selected from the group consisting of the carbonate ions, the hydrogencarbonate ions, the sulfate ions and the acetate ions, is from 0.01 mol/kg to 0.3 mol/kg.

4. The polishing compound according to Claim 1 or 2, wherein the sum of the concentrations of one or more types of ions, which are selected from the group consisting of the carbonate ions, the hydrogencarbonate ions, the sulfate ions and the acetate ions, is from 0.01 mol/kg to 0.2 mol/kg.

5. The polishing compound according to any one of Claims 1 to 4, wherein the concentration of the ammonium ions is at least 0.03 mol/kg.

6. The polishing compound according to any one of Claims 1 to 4, wherein the concentration of the ammonium ions is at least 0.3 mol/kg.

7. The polishing compound according to any one of Claims 1 to 6, wherein the concentration of the organic carboxylate ions is from 0.02 mol/kg to 0.5 mol/kg.

8. The polishing compound according to any one of Claims 1 to 7, wherein the concentration of the organic carboxylate ions is from 0.05 mol/kg to 0.5 mol/kg.

9. The polishing compound according to any one of Claims 1 to 8, wherein the electrolyte comprises at least one member selected from the group consisting of ammonia, ammonium carbonate, ammonium hydrogencarbonate, ammonium sulfate, and ammonium acetate.

10. The polishing compound according to any one of Claims 1 to 9, wherein the organic carboxylate ions are at least one member selected from the group consisting of citrate ions, oxalate ions, malonate ions, succinate ions, phthalate ions, maleate ions, fumarate ions, lactate ions, glycolate ions, gluconate ions and tartrate ions.

11. The polishing compound according to any one of Claims 1 to 10, wherein the abrasive particles are α-alumina.

12. The polishing compound according to any one of Claims 1 to 11, wherein the oxidizing agent is hydrogen peroxide.

13. The polishing compound according to any one of Claims 1 to 12, which has a pH of 6 to 10.

14. The polishing compound according to any one of Claims 1 to 13, which further contains a surface protecting agent for copper.

15. A polishing method comprises polishing a wiring metal by using the polishing compound as defined in any one of Claims 1 to 14.

16. The polishing method according to Claim 15, wherein the wiring metal is either copper or a copper alloy.
